# EUROPEAN PATENT APPLICATION

(11) **EP 4 848 480 A1**
(43) Date of publication of application: **02.12.2026**
(21) Application number: 25213497.8
(22) Date of filing: 04.11.2025
(51) Int. Cl.: H01Q 1/32, H01Q 21/28, H01Q 1/52, G01S 19/36, H01Q 9/04, G01S 19/21

(54) **LOW-PROFILE BUILT-IN VEHICLE-MOUNTED SMART ANTENNA SYSTEM AND VEHICLE**

(30) Priority: 30.05.2025 CN 202510718346
(71) Applicant: Zhejiang Leapmotor Technology Co., Ltd, Hangzhou, Zhejiang 310051 (CN)
(72) Inventor: LIU, Fei, Hangzhou, 310051 (CN); CHEN, Bin, Hangzhou, 310051 (CN); GAO, Jinling, Hangzhou, 310051 (CN)
(74) Representative: Novagraaf Technologies

(57) **Abstract**

The present application relates to the technical field of vehicle-mounted antennas and discloses a low-profile built-in vehicle-mounted smart antenna system and a vehicle. The antenna system includes a PCB, a power supply assembly and a global navigation satellite system unit, in which the PCB includes a first PCB and a second PCB; in a first direction, the first PCB includes a first end and a second end disposed opposite to each other, the second PCB is connected to the second end, and the first direction is perpendicular to a thickness direction of the PCB; the power supply assembly is disposed on the first PCB, and in the first direction, the power supply assembly is closer to the first end than to the second end; and the global navigation satellite system unit is disposed on the second PCB and is adapted to receive satellite signals.

## Description

### Technical Field

The present application relates to the technical field of vehicle-mounted antennas, and particularly to a low-profile built-in vehicle-mounted smart antenna system and a vehicle.

### Background

With the development of mobile communication technology and autonomous driving technology, the demand for wireless communication functions in vehicles has been increasing, and vehicle-mounted antennas are indispensable components for realizing wireless communication functions. Traditional shark-fin antennas and built-in box antennas are both connected to a T-BOX through a low-loss adapter cable of several meters long, which results in high manufacturing costs and poor reliability.

In the related art, a vehicle-mounted antenna system is integrated onto a printed circuit board (PCB) to reduce the cost and loss caused by a split design of the antenna system. However, when the vehicle antenna system is integrated onto a single PCB, a global navigation satellite system unit is susceptible to signal interference from a power supply assembly and other components, thereby reducing the reliability of the vehicle antenna system.

### Summary

The present application provides a low-profile built-in vehicle-mounted smart antenna system and a vehicle, which solves the technical problem that when a vehicle-mounted antenna system is integrated onto a single PCB, a global navigation satellite system unit is susceptible to signal interference from a power supply assembly and other components, thereby reducing the reliability of the vehicle antenna system.

In order to achieve the above objective, the main technical solution adopted in the present application includes:
In a first aspect, the embodiment of the present application provides an antenna system. The antenna system includes a PCB, a power supply assembly and a global navigation satellite system unit, where the PCB includes a first PCB and a second PCB; in a first direction, the first PCB includes a first end and a second end disposed opposite to each other, the second PCB is connected to the second end, and the first direction is perpendicular to a thickness direction of the PCB; the power supply assembly is disposed on the first PCB, and in the first direction, the power supply assembly is closer to the first end than to the second end; and the global navigation satellite system unit is disposed on the second PCB and is adapted to receive satellite signals.

According to the antenna system proposed in the embodiment of the present application, the second PCB is connected to the second end, the global navigation satellite system unit is disposed on the second PCB, and the power supply assembly is disposed on the first PCB. In this way, on the one hand, the global navigation satellite system unit and the power supply assembly are integrated on the PCB without an additional adapter, thereby reducing the manufacturing cost of the antenna system and improving the operating performance of the antenna system. On the other hand, the global navigation satellite system unit is away from interference sources such as the power supply assembly, thereby improving the stability of signal reception of the global navigation satellite system unit.

In some embodiments, in a second direction, the first PCB includes a third end and a fourth end disposed opposite to each other; the length of the first PCB in the first direction is greater than the length of the first PCB in the second direction; and the first direction, the second direction and the thickness direction of the PCB are mutually perpendicular in pairs.

In this way, the distance between the power supply assembly and the global navigation satellite system unit can be further increased, reducing the interference generated by the power supply assembly during operation on the global navigation satellite system unit, and improving the stability and reliability of the operation of the antenna system.

In some embodiments, the antenna system includes a cellular communication unit, the cellular communication unit is disposed on the first PCB, and in the first direction, the cellular communication unit is disposed between the power supply assembly and the second PCB.

The cellular communication unit is disposed on the first PCB, and the global navigation satellite system unit is disposed on the second PCB. In this way, the cellular communication unit and the global navigation satellite system unit are spaced apart, thereby reducing interference of the cellular communication unit with the global navigation satellite system unit.

In some embodiments, the cellular communication unit includes a cellular communication primary unit and a cellular communication diversity unit; the cellular communication primary unit is disposed at the third end, the cellular communication diversity unit is disposed at the second end, and in the first direction, the cellular communication primary unit is disposed between the power supply assembly and the cellular communication diversity unit.

The cellular communication primary unit is disposed at the third end, and the cellular communication diversity unit is disposed at the second end. In this way, the cellular communication primary unit and the cellular communication diversity unit are separately disposed, reducing signal interference between the two, improving the stability of signal transmission, thereby enhancing the communication quality of the antenna system.

In some embodiments, the antenna system includes a first clearance area and a second clearance area, where the first clearance area is disposed at the third end, the second clearance area is disposed at the second end, the cellular communication primary unit is disposed in the first clearance area, and the cellular communication diversity unit is disposed in the second clearance area; in the first direction, the length of the first clearance area is 50-70 mm, and the length of the second clearance area is 8-16 mm; and in the second direction, the length of the first clearance area is 8-16 mm, and the length of the second clearance area is 50-70 mm.

The cellular communication primary unit is disposed in the first clearance area, and the cellular communication diversity unit is disposed in the second clearance area, so that the influence of copper-clad metal on the first PCB on the radiation performance of the cellular communication primary unit and the cellular communication diversity unit can be avoided.

In some embodiments, the PCB includes a first transition portion; in the first direction, one end of the first transition portion is connected to the first PCB, and the other end of the first transition portion is connected to the second PCB; the first transition portion includes a third clearance area and a first connection area; and in the first direction, at least a portion of the cellular communication diversity unit is disposed opposite to the third clearance area, and a copper-clad portion of the second PCB is electrically connected to a copper-clad portion of the first PCB via the first connection area.

At least a portion of the cellular communication diversity unit is disposed opposite to the third clearance area, so that the influence of a copper-clad area of the PCB on signals of the cellular communication diversity unit can be reduced, the signal transmission quality and efficiency of the cellular communication diversity unit can be improved, and the communication stability of the cellular communication diversity unit can be enhanced.

In some embodiments, the copper-clad portion of the second PCB is disposed as a centrosymmetric structure, and the global navigation satellite system unit is disposed as a centrosymmetric structure.

In this way, circular polarization reception and transmission of signals of the global navigation satellite system unit can be better adapted, so that the antenna system can meet communication requirements in different directions, thereby improving signal reception and transmission efficiency.

In some embodiments, the global navigation satellite system unit includes a first ceramic patch and two first pins disposed on the first ceramic patch, and the two first pins are soldered to the second PCB.

The global navigation satellite system unit includes the first ceramic patch and the two first pins disposed on the first ceramic patch, and the two first pins are soldered to the second PCB, so that on the one hand, positioning requirements of the antenna system can be met, and on the other hand, manufacturing costs can be saved.

In some embodiments, the global navigation satellite system unit further includes a second ceramic patch and two second pins disposed on the second ceramic patch; in the thickness direction of the PCB, the first ceramic patch and the second ceramic patch are stacked, the second ceramic patch is closer to the second PCB than the first ceramic patch, the two second pins are soldered to the second PCB, and the two first pins pass through the second ceramic patch and are soldered to the second PCB.

The first ceramic patch and the second ceramic patch are stacked, and the second ceramic patch is closer to the second PCB than the first ceramic patch. Compared with configuring only a single first ceramic patch in the global navigation satellite system unit, the stacking of the first ceramic patch and the second ceramic patch can improve the positioning accuracy of the antenna system.

In some embodiments, in the thickness direction of the PCB, a first bonding layer is disposed between the second ceramic patch and the second PCB, a first foam layer is disposed between the first ceramic patch and an upper cover of the antenna system, and the first foam layer abuts against the first ceramic patch and the upper cover of the antenna system, respectively.

In the thickness direction of the PCB, two sides of the first foam layer may abut against the first ceramic patch and the upper cover of the antenna system, respectively, so that the first ceramic patch and the second ceramic patch can be firmly stacked.

In some embodiments, the antenna system includes a Bluetooth unit, where the Bluetooth unit is disposed at the third end, and in the first direction, the Bluetooth unit is disposed between the cellular communication primary unit and the first end.

The Bluetooth unit is disposed at the third end, and in the first direction, the Bluetooth unit is disposed between the cellular communication primary unit and the first end, so that the influence of a copper-clad structure on the first PCB on signal transmission and reception of the Bluetooth unit can be reduced, thereby improving the operational stability and reliability of the antenna system.

In some embodiments, the Bluetooth unit is etched on the third end of the first PCB.

Etching the Bluetooth unit on the first PCB makes that the Bluetooth unit does not occupy additional space on the first PCB in the thickness direction of the first PCB. This makes the structure of the first PCB more compact, which is conducive to meeting the low-profile requirement of the antenna system. Furthermore, a circuit layout and parameters of the Bluetooth unit can be accurately controlled, thereby reducing signal transmission loss and improving the transmission quality and stability of Bluetooth signals.

In some embodiments, a shortest distance between the Bluetooth unit and the cellular communication primary unit is half a dielectric wavelength.

The shortest distance between the Bluetooth unit and the cellular communication primary unit is half a dielectric wavelength. This enables the Bluetooth unit and the cellular communication primary unit to better transmit and receive signals within respective operating frequency bands thereof, avoiding problems such as antenna radiation pattern distortion and gain reduction caused by excessively short or long distances, thereby improving the overall performance of the antenna system.

In some embodiments, the cellular communication primary unit includes a plurality of first plug-in pins, the cellular communication diversity unit includes a plurality of second plug-in pins, and the plurality of first plug-in pins and the plurality of second plug-in pins are used for signal excitation and grounding as well as structural fixation and support; and in the thickness direction of the PCB, a plurality of first holes and a plurality of second holes penetrating through the first PCB are disposed in the first PCB, each of the plurality of first plug-in pins is fitted into a corresponding first hole, and each of the plurality of second plug-in pins is fitted into a corresponding second hole.

In the thickness direction of the PCB, the plurality of first holes and second holes penetrating through the first PCB are disposed in the first PCB. Each first plug-in pin is fitted into the corresponding first hole, and each second plug-in pin is fitted into the corresponding second hole. Each first plug-in pin may be soldered to the corresponding first hole by a through-hole reflow soldering process, and each second plug-in pin may be soldered to the corresponding second hole by a through-hole reflow soldering process. In this way, manual placement and secondary reflow are not required, thereby realizing automated mounting of the cellular communication primary unit and the cellular communication diversity unit on the first PCB, thereby improving production efficiency and assembly efficiency, and reducing the manufacturing cost of the antenna system.

In some embodiments, the antenna system further includes a Bluetooth chip and a communication chip, where a Bluetooth signal excitation radio frequency link is disposed between the Bluetooth chip and the Bluetooth unit, the Bluetooth signal excitation radio frequency link includes a set of pi-type topology matching positions, a cellular signal excitation primary radio frequency link is disposed between the communication chip and the cellular communication primary unit, a cellular signal excitation diversity radio frequency link is disposed between the communication chip and the cellular communication diversity unit, and both the cellular signal excitation primary radio frequency link and the cellular signal excitation diversity radio frequency link include two sets of pi-type topology matching positions.

The Bluetooth signal excitation radio frequency link includes a set of pi-type topology matching positions, and both the cellular signal excitation primary radio frequency link and the cellular signal excitation diversity radio frequency link include two sets of pi-type topology matching positions, thereby satisfying the signal frequency tuning requirements of the Bluetooth unit, the cellular communication primary unit and the cellular communication diversity unit.

In a second aspect, the embodiment of the present application provides a vehicle, including the antenna system according to any one of the embodiments of the present application.

The vehicle proposed in the embodiment of the present application includes an antenna system, where the second PCB is connected to the second end, the global navigation satellite system unit is disposed on the second PCB, and the power supply assembly is disposed on the first PCB. In this way, on the one hand, the global navigation satellite system unit and the power supply assembly are integrated on the PCB without an additional adapter, thereby reducing the manufacturing cost of the antenna system and improving the operating performance of the antenna system. On the other hand, the global navigation satellite system unit is disposed away from interference sources such as the power supply assembly, thereby improving the stability of signal reception of the global navigation satellite system unit.

In some embodiments, the vehicle includes a vehicle frame, where the vehicle frame includes a first cross beam and a second cross beam; the first cross beam and the second cross beam are spaced apart in a front-rear direction of the vehicle, and the first cross beam and the second cross beam both are disposed above a passenger compartment; and in the front-rear direction of the vehicle, the antenna system is disposed between the first cross beam and the second cross beam and connected to the first cross beam and the second cross beam via connecting members, and the first direction is parallel to at least one of a lengthwise direction of the first cross beam and the second cross beam.

The first cross beam and the second cross beam are both disposed above the passenger compartment. In the front-rear direction of the vehicle, the antenna system is disposed between the first cross beam and the second cross beam, such that the antenna system is positioned relatively high with fewer surrounding obstructions, thereby enabling the antenna system to better receive and transmit signals, and improving communication quality and stability.

### Brief Description of the Drawings

In order to explain the embodiments of the present application or the technical solutions in the prior art more clearly, the accompanying drawings required by the specific embodiments or descriptions in the prior art are introduced briefly below. Obviously, the accompanying drawings in the description below are merely some embodiments of the present application. Those of ordinary skill in the art can also obtain other accompanying drawings based on the provided accompanying drawings without paying creative work.
FIG. 1 is a schematic structural diagram of an antenna system according to an embodiment of the present application;
FIG. 2 is a schematic structural diagram of an antenna system, a first cross beam and a second cross beam according to an embodiment of the present application;
FIG. 3 is a usage scenario diagram of the antenna system applied to a vehicle according to an embodiment of the present application.

Description of reference numerals: 1000, vehicle; 100, antenna system; 110, PCB; 120, first PCB; 121, first end; 122, second end; 123, third end; 124, fourth end; 130, second PCB; 140, power supply assembly; 150, global navigation satellite system unit; 160, cellular communication unit; 161, cellular communication primary unit; 162, cellular communication diversity unit; 170, first clearance area; 171, second clearance area; 180, first transition portion; 181, third clearance area; 182, first connection area; 190, Bluetooth unit; 200, Bluetooth chip; 210, communication chip; 220, satellite chip; 230, vehicle frame; 231, first cross beam; 232, second cross beam; 240, connecting member; 250, first groove; 260, roof glass; X, first direction; Y, second direction.

### Detailed Description of the Embodiments

In order to make the objectives, technical solutions and advantages of embodiments of the present application clearer, the technical solutions in the embodiments of the present application will be described clearly and completely below with reference to the accompanying drawings in the embodiments of the present application. Apparently, the embodiments described are some of, rather than all of, the embodiments of the present application. Based on the embodiments of the present application, all other embodiments obtained by those skilled in the art without any creative effort shall fall within the scope of protection of the present application.

Unless otherwise defined, all technical and scientific terms used in the present application have the same meaning as commonly understood by those skilled in the art to which the present application pertains. The terms used in the description of the present application are to describe specific embodiments only and are not intended to limit the present application. The terms "including" and "having" and any variations thereof in the specification and claims of the present application and the above brief description of the accompanying drawings are intended to cover a non-exclusive inclusion. The terms "first", "second", and so on in the description and claims or accompanying drawings of the present application are intended to distinguish different objects, but not to describe particular sequences or primary-secondary relationships.

The "embodiments" mentioned in the present application mean that specific features, structures or characteristics described in conjunction with embodiments may be included in at least one embodiment of the present application. The phrases appearing at positions of the description do not necessarily indicate the same embodiment, and it is not an exclusively independent or alternative embodiment of other embodiments. Those skilled in the art understand implicitly and explicitly that the embodiments described in the present application can be combined with other embodiments.

In the description of the present application, it should also be noted that unless otherwise expressly specified and limited, the terms "mount", "joint", "connect" and "attach" should be understood in a broad sense, for example, it can be a fixed connection or a detachable connection, or be integrally connected; it can be directly connected or indirectly connected through an intermediate medium, and it can be an internal communication between two components. The specific meanings of the above terms in the present application may be understood by those of ordinary skill in the art depending on specific circumstances.

The term "and/or" in this application is simply a description of the association relationship of the associated objects, indicating that three relationships can exist, for example, A and/or B, which can mean: A exists alone, both A and B exist, and B exists alone. In addition, the character "/" in the present application generally indicates an alternative relationship between the front and back associated objects.

As used in the present application, "a plurality of" refers to more than two (includes two), similarly, "multiple sets" refers to more than two sets (includes two sets), and "multichip" refers to more than two chips (includes two chips).

With the development of mobile communication technology and autonomous driving technology, automobiles have transformed from mere transportation vehicles into highly smart mobile terminals, and the demand for in-vehicle entertainment, Internet of Vehicles, remote control and other wireless communication functions has grown explosively. As a core hardware for realizing these wireless communication functions, the importance of the performance and design scheme of a vehicle antenna has become increasingly prominent.

In traditional vehicle antenna solutions, shark-fin antennas and built-in BOX antennas are relatively common. Such antennas are connected to a Telematics BOX (T-BOX, telematics terminal) through low-loss adapter cables of several meters long. However, the split-type design has obvious disadvantages. On the one hand, the manufacturing of long adapter cables requires the use of high-grade shielding materials and precision processes, resulting in high material and assembly costs. On the other hand, the joints of the adapter cables are prone to poor contact due to vehicle bumping and vibration, while the long cables also increase signal loss and the risk of external electromagnetic interference, making it difficult to ensure the reliability of the entire antenna system.

In the related art, a design concept of integrating a vehicle-mounted antenna system onto a single PCB has been proposed. In this integrated solution, functional components such as antenna radiation units, feed networks, and signal processing modules are directly arranged on the same PCB, effectively reducing the connection loss and assembly cost caused by a split-type design. However, when a global navigation satellite system unit is closely arranged together with components such as a power supply assembly, a processor, and a memory on the same PCB, signal interference between different modules is likely to occur. For example, electromagnetic noise generated by the power supply assembly during operation may couple into a signal transmission path of the global navigation satellite system unit, resulting in a decrease in satellite signal reception sensitivity, and high-frequency harmonics generated by the processor during high-speed operation may also interfere with the satellite communication frequency band, ultimately causing the overall reliability of the vehicle antenna system to be significantly reduced.

In view of this, the embodiment of the present application provides a low-profile built-in vehicle-mounted smart antenna system and a vehicle. The antenna system includes a PCB, a power supply assembly and a global navigation satellite system unit, where the PCB includes a first PCB and a second PCB; in a first direction, the first PCB includes a first end and a second end disposed opposite to each other, the second PCB is connected to the second end, and the first direction is perpendicular to a thickness direction of the PCB; the power supply assembly is disposed on the first PCB, and in the first direction, the power supply assembly is closer to the first end than to the second end; and the global navigation satellite system unit is disposed on the second PCB and is adapted to receive satellite signals.

In the above solution, the second PCB is connected to the second end, the global navigation satellite system unit is disposed on the second PCB, and the power supply assembly is disposed on the first PCB. In this way, on the one hand, the global navigation satellite system unit and the power supply assembly are integrated on the PCB without an additional adapter, thereby reducing the manufacturing cost of the antenna system and improving the operating performance of the antenna system. On the other hand, the global navigation satellite system unit is disposed away from interference sources such as the power supply assembly, thereby improving the stability of signal reception of the global navigation satellite system unit.

For ease of description, the following embodiments take a low-profile built-in vehicle-mounted smart antenna system according to an embodiment of the present application as an example for illustration.

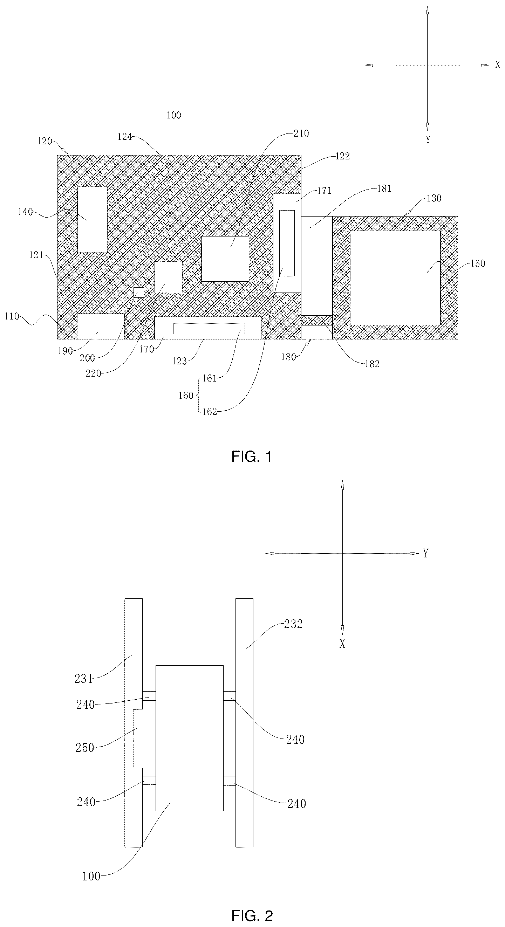

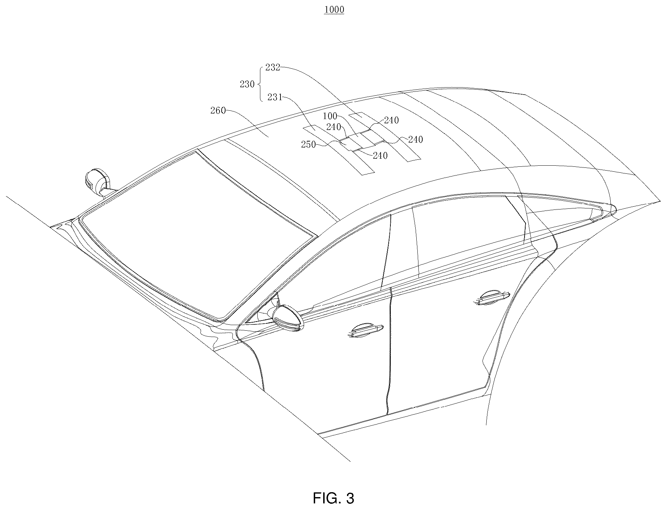

FIG. 1 is a schematic structural diagram of an antenna system according to an embodiment of the present application; FIG. 2 is a schematic structural diagram of an antenna system, a first cross beam and a second cross beam according to an embodiment of the present application; and FIG. 3 is a usage scenario diagram of the antenna system applied to a vehicle according to an embodiment of the present application.

Referring to FIG. 1 and FIG. 2, the antenna system 100 includes a PCB 110, a power supply assembly 140 and a global navigation satellite system unit 150, where the PCB 110 includes a first PCB 120 and a second PCB 130. In a first direction X, the first PCB 120 includes a first end 121 and a second end 122 disposed opposite to each other, the second PCB 130 is connected to the second end 122, and the first direction X is perpendicular to a thickness direction of the PCB 110; the power supply assembly 140 is disposed on the first PCB 120, and in the first direction X, the power supply assembly 140 is closer to the first end 121 than to the second end 122; and the global navigation satellite system unit 150 is disposed on the second PCB 130 and is adapted to receive satellite signals.

The PCB 110 refers to a printed circuit board. Copper conductive circuits are formed on a surface of the PCB 110 using an insulating plate as a base material through processes such as printing and etching. A copper-clad area is provided on the PCB 110, and a ground layer on the PCB 110 is subjected to large-area copper cladding, so that a cross-sectional area of a ground conductor can be increased, thereby effectively reducing ground resistance, reducing a probability of interference between different components on the PCB 110 due to a ground potential difference, and improving the stability and reliability of operation of the entire antenna system 100. For example, in a high-frequency circuit, a smaller ground impedance can reduce inductance in a signal return path, preventing signal reflection and oscillation.

The PCB 110 includes a first PCB 120 and a second PCB 130. In the first direction X, the first PCB 120 includes the first end 121 and the second end 122 disposed opposite to each other, and the second PCB 130 is disposed at the second end 122 of the first PCB 120, that is, the second PCB 130 is disposed at a position away from the first end 121.

The power supply assembly 140 is disposed on the first PCB 120. During operation, the power supply assembly 140 generates a large number of interference sources, such as electromagnetic noise and harmonics. These interference sources interfere with the operation of the global navigation satellite system unit 150. If the power supply assembly 140 is too close to the global navigation satellite system unit 150, satellite positioning failures may easily occur. The power supply assembly 140 is disposed on the first PCB 120, and in the first direction X, the power supply assembly 140 is closer to the first end 121 than to the second end 122, such that the power supply assembly 140 is disposed on the first PCB 120 at a position away from the second PCB 130. The global navigation satellite system unit 150 is used to receive satellite signals, and the global navigation satellite system unit 150 can meet the positioning requirements of the vehicle. The global navigation satellite system unit 150 is disposed on the second PCB 130, and in the first direction X, the global navigation satellite system unit 150 is disposed on a side of the first PCB 120 away from the power supply assembly 140. In this way, the global navigation satellite system unit 150 and the power supply assembly 140 are separated, thereby avoiding interference from the power supply assembly 140 to the global navigation satellite system unit 150 during operation.

By way of example, the first PCB 120 may be disposed as a main board, and components such as a memory unit of the antenna system 100 may be disposed on the first PCB 120. The global navigation satellite system unit 150 is disposed on the second PCB 130 and separated from the memory unit and other components, so that interference from the components on the first PCB 120 to the global navigation satellite system unit 150 can be reduced, thereby improving the stability and reliability of the operation of the antenna system 100.

Moreover, the global navigation satellite system unit 150 is disposed on the second PCB 130 instead of the first PCB 120, avoiding occupation of space on the first PCB 120 by the global navigation satellite system unit 150, thereby improving the heat dissipation effect of the components disposed on the first PCB 120.

The second PCB 130 is connected to the second end 122, and the first direction X is perpendicular to the thickness direction of the PCB 110. By way of example, the second PCB 130 may be disposed at the second end 122, and in the thickness direction of the PCB 110, projections of the first PCB 120 and the second PCB 130 may not overlap, thereby reducing the length of the antenna system 100 in the thickness direction of the PCB 110, facilitating flattening of the antenna system 100, and enabling easier installation of the antenna system 100 on the top of the vehicle 1000.

The antenna system 100 integrates the power supply assembly 140 and the global navigation satellite system unit 150 on the PCB 110 without the need for connecting components such as jumper cables, thereby improving the stability and reliability of the operation of the antenna system 100, and reducing the manufacturing cost of the antenna system 100.

Referring to FIG. 1 and FIG. 2, in the present embodiment, in a second direction Y, the first PCB 120 includes a third end 123 and a fourth end 124 disposed opposite to each other. The length of the first PCB 120 in the first direction X is greater than the length of the first PCB 120 in the second direction Y. The first direction X, the second direction Y and the thickness direction of the PCB 110 are mutually perpendicular in pairs.

By way of example, the first PCB 120 may be disposed as a rectangular structure, and the length of the first PCB 120 in the first direction X is greater than the length of the first PCB 120 in the second direction Y. That is, the power supply assembly 140 and the second PCB 130 may be disposed at two ends of the first PCB 120 in a length direction, such that a distance between the power supply assembly 140 and the global navigation satellite system unit 150 is increased, thereby reducing interference of the power supply assembly 140 with the global navigation satellite system unit 150 during operation, and improving the stability and reliability of operation of the antenna system 100.

Referring to FIG. 1 and FIG. 2, in the present embodiment, the antenna system 100 includes a cellular communication unit 160, the cellular communication unit 160 is disposed on the first PCB 120, and in the first direction X, the cellular communication unit 160 is disposed between the power supply assembly 140 and the second PCB 130.

The cellular communication unit 160 is used to enable the vehicle 1000 to access an Internet of Vehicles, so that the vehicle 1000 can obtain real-time traffic information, receive remote instructions, upload state data of the vehicle 1000, and the like. The cellular communication unit 160 may be a 4G cellular communication unit, a 5G cellular communication unit, or a 6G cellular communication unit.

The cellular communication unit 160 is disposed on the first PCB 120, and the global navigation satellite system unit 150 is disposed on the second PCB 130, such that the cellular communication unit 160 and the global navigation satellite system unit 150 are spaced apart, thereby reducing disturbance of the cellular communication unit 160 to the global navigation satellite system unit 150.

The cellular communication unit 160 and the power supply assembly 140 are both disposed on the first PCB 120, and the global navigation satellite system unit 150 is disposed on the second PCB 130, such that the antenna system 100 integrates the cellular communication unit 160, the power supply assembly 140 and the global navigation satellite system unit 150 without the need for complex jumper cables or the like to connect the components, thereby reducing the manufacturing cost of the antenna system 100, reducing signal loss in the jumper cables, and improving reliability of the antenna system 100.

Referring to FIG. 1 and FIG. 2, in the present embodiment, the cellular communication unit 160 includes a cellular communication primary unit 161 and a cellular communication diversity unit 162. The cellular communication primary unit 161 is disposed at the third end 123, the cellular communication diversity unit 162 is disposed at the second end 122, and in the first direction X, the cellular communication primary unit 161 is disposed between the power supply assembly 140 and the cellular communication diversity unit 162.

The cellular communication primary unit 161 is mainly responsible for signal transmission and reception, and the cellular communication diversity unit 162 assists the cellular communication primary unit 161 in signal reception. The cellular communication primary unit 161 is disposed at the third end 123, and the cellular communication diversity unit 162 is disposed at the second end 122. By way of example, in the first direction X, the cellular communication primary unit 161 and the cellular communication diversity unit 162 may be spaced apart from each other, such that the cellular communication primary unit 161 and the cellular communication diversity unit 162 are separated from each other, thereby reducing signal interference between the two, improving stability of signal transmission, and further improving communication quality of the antenna system 100.

In the first direction X, the cellular communication primary unit 161 is disposed between the power supply assembly 140 and the cellular communication diversity unit 162. In the first direction X, the cellular communication primary unit 161 may be disposed spacing apart from both the power supply assembly 140 and the cellular communication diversity unit 162, thereby reducing the probability of mutual interference between the components.

By way of example, the first PCB 120 may be disposed as a rectangular structure, and the third end 123 of the first PCB 120 may be a long edge of the first PCB 120. The cellular communication primary unit 161 may be disposed on the long edge of the first PCB 120. When operating, the cellular communication primary unit 161 transmits signals in the second direction Y and away from the fourth end 124. Accordingly, by disposing the cellular communication primary unit 161 at the third end 123 of the first PCB 120, that is, at the long edge of the first PCB 120, the cellular communication primary unit 161 can transmit and receive signals more smoothly, thereby improving the stability and reliability of operation of the antenna system 100.

Moreover, the cellular communication primary unit 161 is disposed at the third end 123, and the cellular communication diversity unit 162 is disposed at the second end 122. The cellular communication primary unit 161 can transmit and receive signals in the second direction Y and away from the first PCB 120, and the cellular communication diversity unit 162 can receive signals in the first direction X and away from the first PCB 120. In this way, the antenna system 100 can transmit and receive signals in various directions, reducing the occurrence of signal blind areas.

Referring to FIG. 1 and FIG. 2, the antenna system 100 includes a first clearance area 170 and a second clearance area 171. The first clearance area 170 is disposed at the third end 123, the second clearance area 171 is disposed at the second end 122, the cellular communication primary unit 161 is disposed in the first clearance area 170, and the cellular communication diversity unit 162 is disposed in the second clearance area 171; in the first direction X, the length of the first clearance area 170 is 50-70 mm, and the length of the second clearance area 171 is 8-16 mm; and in the second direction X, the length of the first clearance area 170 is 8-16 mm, and the length of the second clearance area 171 is 50-70 mm.

The antenna system 100 further includes the first clearance area 170 and the second clearance area 171. The first clearance area 170 and the second clearance area 171 are disposed on the first PCB 120. No copper-clad structure is disposed in the first clearance area 170 and the second clearance area 171. The cellular communication primary unit 161 is disposed in the first clearance area 170, and the cellular communication diversity unit 162 is disposed in the second clearance area 171, thereby avoiding the influence of the copper-clad metal on the first PCB 120 on the radiation performance of the cellular communication primary unit 161 and the cellular communication diversity unit 162.

By way of example, in the second direction Y, the first clearance area 170 may be adjacent to or abut against an edge of the first PCB 120 at the third end 123, and the second clearance area 171 may be adjacent to or abut against an edge of the first PCB 120 at the second end 122. In this way, the influence of the copper-clad structure of the first PCB 120 on the radiation performance of the cellular communication primary unit 161 and the influence of the copper-clad structure of the first PCB 120 on the radiation performance of the cellular communication diversity unit 162 can be reduced.

The area of the first clearance area 170 may be greater than the area of the cellular communication primary unit 161, and the area of the second clearance area 171 may be greater than the area of the cellular communication diversity unit 162. In the first direction X, the length of the first clearance area 170 is 50-70 mm, for example, 50 mm, 55 mm, 60 mm, 65 mm, or 70 mm. In the first direction X, the length of the second clearance area 171 is 8-16 mm, for example, 8 mm, 10 mm, 12 mm, 14 mm, or 16 mm. In the second direction Y, the length of the first clearance area 170 is 8-16 mm, for example, 8 mm, 10 mm, 12 mm, 14 mm, or 16 mm, and the length of the second clearance area 171 is 50-70 mm, for example, 50 mm, 55 mm, 60 mm, 65 mm, or 70 mm. In this way, under the condition that the transmission and reception of signals of the cellular communication primary unit 161 and the reception of signals of the cellular communication diversity unit 162 are not affected, the occupation of the area of the first PCB 120 by the first clearance area 170 and the second clearance area 171 is minimized as much as possible, so that the structure of the first PCB 120 is more compact, thereby improving the compactness of the structure of the antenna system 100.

Referring to FIG. 1 and FIG. 2, in the present embodiment, the PCB 110 includes a first transition portion 180; in the first direction X, one end of the first transition portion 180 is connected to the first PCB 120, and the other end of the first transition portion 180 is connected to the second PCB 130; the first transition portion 180 includes a third clearance area 181 and a first connection area 182; and in the first direction X, at least a portion of the cellular communication diversity unit 162 is disposed opposite to the third clearance area 181, and a copper-clad portion of the second PCB 130 is electrically connected to a copper-clad portion of the first PCB 120 via the first connection area 182.

The PCB 110 includes the first transition portion 180. In the first direction X, the first transition portion 180 is disposed between the first PCB 120 and the second PCB 130 and connected to the first PCB 120 and the second PCB 130, respectively. The first transition portion 180 includes the third clearance area 181 and the first connection area 182. The first connection area 182 is electrically connected to the first PCB 120 and the second PCB 130, and no copper-clad structure is disposed on the third clearance area 181. In the first direction X, at least a portion of the cellular communication diversity unit 162 is disposed opposite to the third clearance area 181. For example, in the first direction X, the cellular communication diversity unit 162 may be disposed opposite to the third clearance area 181; in the first direction X, at least a portion of the cellular communication diversity unit 162 may be disposed opposite to the third clearance area 181. Since the cellular communication diversity unit 162 can receive signals in the first direction X and away from the first PCB 120, at least a portion of the cellular communication diversity unit 162 being disposed opposite to the third clearance area 181 in the first direction X, the influence of the copper-clad area of the PCB 110 on the signals of the cellular communication diversity unit 162 can be reduced, thereby improving the signal transmission quality and efficiency of the cellular communication diversity unit 162, and enhancing the communication stability of the cellular communication diversity unit 162.

The copper-clad portion of the second PCB 130 is electrically connected to the copper-clad portion of the first PCB 120 via the first connection area 182. By way of example, the first connection area 182 may be made of copper or materials capable of electrically connecting the copper-clad portions of the first PCB 120 and the second PCB 130, thereby electrically connecting the first PCB 120 and the second PCB 130.

Referring to FIG. 1 and FIG. 2, in the present embodiment, the copper-clad portion of the second PCB 130 is disposed as a centrosymmetric structure, and the global navigation satellite system unit 150 is disposed as a centrosymmetric structure.

By way of example, the second PCB 130 may be disposed as a centrosymmetric structure, the copper-clad portion of the second PCB 130 may be disposed as a centrosymmetric structure, and the global navigation satellite system unit 150 is disposed on the copper-clad portion of the second PCB 130, thereby better accommodating the reception of circularly polarized signals of the global navigation satellite system unit 150, enabling the antenna system 100 to adapt to communication requirements in different directions, and improving signal reception efficiency.

By way of example, the global navigation satellite system unit 150 is disposed as a centrosymmetric structure.

Referring to FIG. 1 and FIG. 2, in the present embodiment, the global navigation satellite system unit 150 includes a first ceramic patch and two first pins disposed on the first ceramic patch, and the two first pins are soldered to the second PCB 130.

The global navigation satellite system unit 150 includes the first ceramic patch. A dielectric constant of a ceramic structure is greater than a dielectric constant of vacuum, so that the wavelength of an electromagnetic wave at the same frequency in the first ceramic patch is shorter than the wavelength in vacuum. Since the dimension of the global navigation satellite system unit 150 is related to the wavelength, the global navigation satellite system unit 150 includes the first ceramic patch, such that the dimension of the global navigation satellite system unit 150 can be smaller while meeting the satellite navigation and positioning function. This facilitates the reduction in dimension of the global navigation satellite system unit 150 and makes it easier to integrate the global navigation satellite system unit 150 onto the PCB 110.

The two first pins are disposed on the first ceramic patch, and the two first pins are inserted into the second PCB 130. By way of example, a satellite chip 220 may further be disposed on the first PCB 120, and both the satellite chip 220 and the global navigation satellite system unit 150 are integrated on the PCB 110, so that the structure of the antenna system 100 is more compact.

The two first pins can serve to solder the first ceramic patch with the second PCB 130 on the one hand, and can also serve to provide signal excitation on the other hand. By exciting signals of an equal amplitude with a phase difference of 90 degrees via the two first pins, circular polarization is realized, thereby better receiving signals from satellites.

The global navigation satellite system unit 150 includes only one first ceramic patch, which can meet the positioning requirements of the antenna system 100, for example, satisfying the Beidou B1 frequency band or the GPS L1 frequency band. This not only meets the positioning requirements of the antenna system 100, but also saves manufacturing costs.

Referring to FIG. 1 and FIG. 2, in the present embodiment, the global navigation satellite system unit 150 further includes a second ceramic patch and two second pins disposed on the second ceramic patch; in the thickness direction of the PCB 110, the first ceramic patch and the second ceramic patch are stacked, the second ceramic patch is closer to the second PCB 130 than the first ceramic patch, the two second pins are soldered to the second PCB 130, and the two first pins pass through the second ceramic patch and are soldered to the second PCB 130.

The two second pins can serve to solder the second ceramic patch to the second PCB 130 on the one hand, and can also serve to provide signal excitation on the other hand. By exciting signals of an equal amplitude with a phase difference of 90 degrees via the two second pins, circular polarization is realized, thereby better receiving signals from satellites.

In the thickness direction of the PCB 110, the first ceramic patch is farther away from the second PCB 130 than the second ceramic patch, and the two first pins may pass through the second ceramic patch and be soldered to the second PCB 130.

The global navigation satellite system unit 150 includes the first ceramic patch and the second ceramic patch, which are stacked, thereby meeting the high-precision positioning requirements of the antenna system 100, for example, meeting the requirements of GPS L1 or L5 frequency bands, and Beidou B1 or B2 frequency bands. Compared with only providing one first ceramic patch in the global navigation satellite system unit 150, the stacking of the first ceramic patch and the second ceramic patch can improve the positioning accuracy of the antenna system 100. In addition, the stacking of the first ceramic patch and the second ceramic patch can also reduce the area occupied by the global navigation satellite system unit 150 on a plane of the second PCB 130.

By way of example, the diameter of the first pins may be larger than the diameter of the second pins, so that during assembly, an assembly operator will not insert the first ceramic patch and the second ceramic patch incorrectly, thereby achieving physical fool-proofing and improving assembly efficiency of the assembly operator.

In some embodiments, the area of the second ceramic patch is larger than that of the first ceramic patch, such that the first ceramic patch can be stacked on the second ceramic patch more stably.

Referring to FIG. 1 and FIG. 2, in the present embodiment, in the thickness direction of the PCB 110, a first bonding layer is disposed between the second ceramic patch and the second PCB 130, a first foam layer is disposed between the first ceramic patch and an upper cover of the antenna system 100, and the first foam layer abuts against the first ceramic patch and the upper cover of the antenna system 100, respectively.

The materials of the first bonding layer may be disposed by adhesives, thereby bonding the second ceramic patch to the second PCB 130, and bonding the second ceramic patch and the second PCB 130 more firmly. In the thickness direction of the PCB 110, the first foam layer is disposed on a side of the first ceramic patch away from the second ceramic patch. By way of example, a housing of the antenna system 100 may be disposed as a box body, and the antenna system 100 may include an upper cover and a lower cover. In the thickness direction of the PCB 110, the first ceramic patch is closer to the upper cover than the second ceramic patch. In the thickness direction of the PCB 110, two sides of the first foam layer may abut against the first ceramic patch and the upper cover of the antenna system 100, respectively, thereby enabling the first ceramic patch and the second ceramic patch to be more firmly stacked together.

Referring to FIG. 1 and FIG. 2, in the present embodiment, the antenna system 100 includes a Bluetooth unit 190. The Bluetooth unit 190 is disposed at the third end 123. In the first direction X, the Bluetooth unit 190 is disposed between the cellular communication primary unit 161 and the first end 121.

By way of example, the Bluetooth unit 190 is disposed at the third end 123, and the Bluetooth unit 190 may be spaced apart from the power supply assembly 140. In this way, during operation of the Bluetooth unit 190, interference from the power supply assembly 140 to the Bluetooth unit 190 is reduced, thereby improving the stability and reliability of the operation of the antenna system 100.

In the first direction X, the Bluetooth unit 190 is disposed between the cellular communication primary unit 161 and the first end 121, and the Bluetooth unit 190 may be spaced apart from the cellular communication primary unit 161, thereby reducing electromagnetic interference between the cellular communication primary unit 161 and the Bluetooth unit 190.

Moreover, the Bluetooth unit 190 is disposed at the third end 123. By way of example, the Bluetooth unit 190 may be disposed at an edge of the third end 123 of the first PCB 120; in the second direction Y, the Bluetooth unit 190 may transmit signals in a direction away from the PCB 110. By disposing the Bluetooth unit 190 at the third end 123, the influence of the copper-clad structure on the first PCB 120 on signal transmission and reception of the Bluetooth unit 190 can be reduced, thereby improving the stability and reliability of the operation of the antenna system 100.

Referring to FIG. 1 and FIG. 2, in the present embodiment, the Bluetooth unit 190 is etched on the third end 123 of the first PCB 120.

Since the bandwidth of the Bluetooth unit 190 is relatively narrow, when the Bluetooth unit 190 is etched on the first PCB 120, the Bluetooth unit 190 occupies only a small space of the first PCB 120. The Bluetooth unit 190 is etched on the first PCB 120, that is, the Bluetooth unit 190 and the first PCB 120 are integrally formed. During the manufacturing process of the first PCB 120, the Bluetooth unit 190 is disposed on the first PCB 120, so that in the thickness direction of the first PCB 120, the Bluetooth unit 190 does not additionally occupy the space of the first PCB 120, thereby allowing the structure of the first PCB 120 to be more compact, which facilitates meeting the low-profile requirement of the antenna system 100. Moreover, by etching the Bluetooth unit 190 on the first PCB 120, the circuit layout and parameters of the Bluetooth unit 190 can be precisely controlled, reducing the loss of signal transmission, and improving the transmission quality and stability of Bluetooth signals.

Referring to FIG. 1 and FIG. 2, in the present embodiment, the shortest distance between the Bluetooth unit 190 and the cellular communication primary unit 161 is half a dielectric wavelength.

Within the first PCB 120, the shortest distance between the Bluetooth unit 190 and the cellular communication primary unit 161 is half the dielectric wavelength, that is, the distance between the Bluetooth unit 190 and the cellular communication primary unit 161 is half a same-frequency wavelength of the Bluetooth unit 190 and the cellular communication primary unit 161. This minimizes the electromagnetic interference between the Bluetooth unit 190 and the cellular communication primary unit 161, thereby ensuring the integrity and stability of the respective signals of the Bluetooth unit 190 and the cellular communication primary unit 161, and improving communication quality.

Moreover, the shortest distance between the Bluetooth unit 190 and the cellular communication primary unit 161 is half the dielectric wavelength. This enables the Bluetooth unit 190 and the cellular communication primary unit 161 to better transmit and receive signals within respective operating frequency bands thereof, avoiding problems such as antenna radiation pattern distortion and gain reduction caused by excessively short distances, thereby improving the overall performance of the antenna system 100.

Referring to FIG. 1 and FIG. 2, in the present embodiment, the cellular communication primary unit 161 includes a plurality of first plug-in pins, the cellular communication diversity unit 162 includes a plurality of second plug-in pins, and the plurality of first plug-in pins and the plurality of second plug-in pins both are used for signal excitation and grounding as well as structural fixation and support; and in the thickness direction of the PCB 110, a plurality of first holes and a plurality of second holes penetrating through the first PCB 120 are disposed in the first PCB 120, each first plug-in pin is fitted into a corresponding first hole, and each second plug-in pin is fitted into a corresponding second hole.

In the prior art, the cellular communication primary unit 161 and the cellular communication diversity unit 162 are formed by thermally fusing steel sheets to a plastic bracket so as to fix the steel sheets onto a circuit board. In the embodiment of the present application, the cellular communication primary unit 161 and the cellular communication diversity unit 162 each may be formed by folding a whole steel sheet into a shape. By increasing the thickness of the steel sheet in the embodiment of the present application, the probability of deformation and damage of the steel sheet can be reduced.

The cellular communication primary unit 161 includes the plurality of first plug-in pins, and the cellular communication diversity unit 162 includes the plurality of second plug-in pins. The plurality of first plug-in pins and the plurality of second plug-in pins are used for signal excitation and grounding as well as structural fixation and support. In this way, the cellular communication primary unit 161 and the cellular communication diversity unit 162 are fixed to the first PCB 120 via the plurality of first plug-in pins and the plurality of second plug-in pins. Compared with being mounted to the first PCB 120 through a plastic bracket, mold opening costs and material costs of the plastic bracket can be reduced, thereby reducing the manufacturing cost of the antenna system 100.

By way of example, the plurality of first plug-in pins may be four first plug-in pins, and the plurality of second plug-in pins may be four second plug-in pins. Two of the first plug-in pins may be used for structural fixation and support, and the other two of the first plug-in pins may be used for signal excitation and grounding. Two of the second plug-in pins may be used for structural fixation and support, and the other two of the second plug-in pins may be used for signal excitation and grounding.

The first PCB 120 includes the plurality of first holes and the plurality of second holes. In a thickness direction of the PCB 110, the plurality of first holes and the plurality of second holes penetrate through the first PCB 120. Each first plug-in pin may be soldered to the corresponding first hole by through-hole reflow soldering process, and each second plug-in pin may be soldered to the corresponding second hole by through-hole reflow soldering process. In this way, manual placement and secondary reflow pass are not required, thereby realizing automated mounting of the cellular communication primary unit 161 and the cellular communication diversity unit 162 on the first PCB 120, improving production efficiency and assembly efficiency, and reducing the manufacturing cost of the antenna system 100.

By way of example, the cellular communication primary unit 161 and the cellular communication diversity unit 162 provided in the embodiment of the present application operate in a frequency band covering 698-960 MHz and 1710-2690 MHz.

Referring to FIG. 1 and FIG. 2, in the present embodiment, the antenna system 100 further includes a Bluetooth chip 200 and a communication chip 210, where a Bluetooth signal excitation radio frequency link is disposed between the Bluetooth chip 200 and the Bluetooth unit 190, and the Bluetooth signal excitation radio frequency link includes a set of pi-type topology matching positions; a cellular signal excitation primary radio frequency link is disposed between the communication chip 210 and the cellular communication primary unit 161, a cellular signal excitation diversity radio frequency link is disposed between the communication chip 210 and the cellular communication diversity unit 162, and both the cellular signal excitation primary radio frequency link and the cellular signal excitation diversity radio frequency link include two sets of pi-type topology matching positions.

The Bluetooth signal excitation radio frequency link is disposed between the Bluetooth chip 200 and the Bluetooth unit 190, and the Bluetooth chip 200 and the Bluetooth unit 190 perform mutual signal transmission via the Bluetooth signal excitation radio frequency link. The Bluetooth chip 200 and the communication chip 210 may both be disposed on the first PCB 120. Since the operating bandwidth of the Bluetooth unit 190 is relatively narrow, the Bluetooth signal excitation radio frequency link including one set of pi-type topology matching positions can meet the signal frequency tuning requirement of the Bluetooth unit 190.

The cellular signal excitation primary radio frequency link is disposed between the cellular communication primary unit 161 and the communication chip 210, and the cellular communication primary unit 161 and the communication chip 210 perform mutual signal transmission via the cellular signal excitation primary radio frequency link. Since the cellular communication primary unit 161 is a multi-frequency wideband antenna, two sets of pi-type topology matching positions being disposed on the cellular signal excitation primary radio frequency link can meet the tuning requirement of the cellular communication primary unit 161.

The cellular signal excitation diversity radio frequency link is disposed between the cellular communication diversity unit 162 and the communication chip 210, and the cellular communication diversity unit 162 and the communication chip 210 perform mutual signal transmission via the cellular signal excitation diversity radio frequency link. Since the cellular communication diversity unit 162 is a multi-frequency wideband antenna, two sets of pi-type topology matching positions being disposed on the cellular signal excitation diversity radio frequency link can meet the tuning requirement of the cellular communication diversity unit 162.

Referring to FIG. 1 and FIG. 3, the embodiment of the present application provides a vehicle 1000. The vehicle 1000 includes the antenna system 100 according to any one of the embodiments of the present application.

The vehicle 1000 proposed in the embodiment of the present application includes an antenna system 100, where the second PCB 130 is connected to the second end 122, the global navigation satellite system unit 150 is disposed on the second PCB 130, and the power supply assembly 140 is disposed on the first PCB 120. In this way, on the one hand, the global navigation satellite system unit 150 and the power supply assembly 140 are integrated on the PCB 110 without an additional adapter, thereby reducing the manufacturing cost of the antenna system 100, and improving the operating performance of the antenna system 100. On the other hand, the global navigation satellite system unit 150 is disposed away from interference sources such as the power supply assembly 140, thereby improving the stability of signal reception of the global navigation satellite system unit 150.

Referring to FIG. 1 and FIG. 3, in the present embodiment, the vehicle 1000 includes a vehicle frame 230, where the vehicle frame 230 includes a first cross beam 231 and a second cross beam 232; the first cross beam 231 and the second cross beam 232 are spaced apart in a front-rear direction of the vehicle 1000, and the first cross beam 231 and the second cross beam 232 both are disposed above a passenger compartment; and in the front-rear direction of the vehicle 1000, the antenna system 100 is disposed between the first cross beam 231 and the second cross beam 232 and connected to the first cross beam 231 and the second cross beam 232 via connecting members 240, and the first direction X is parallel to at least one of a lengthwise direction of the first cross beam 231 and a lengthwise direction of the second cross beam 232.

The lengthwise direction of the first cross beam 231 and the second cross beam 232 are both parallel to a left-right direction of the vehicle 1000. The first cross beam 231 and the second cross beam 232 are spaced apart in the front-rear direction of the vehicle 1000. By way of example, the antenna system 100 may be connected to the first cross beam 231 and the second cross beam 232 via brackets or other connecting members 240, so that the antenna system 100 is fixed to the vehicle 1000.

The vehicle 1000 may further include a roof glass 260. In an up-down direction of the vehicle 1000, the roof glass 260 is disposed above the first cross beam 231 and the second cross beam 232, and the antenna system 100 may be disposed below the roof glass 260. That is, the antenna system 100 may be disposed inside the vehicle 1000. Compared with an exposed shark-fin antenna of the antenna system 100, the antenna system 100 is disposed below the roof glass 260, thereby on the one hand, eliminating the need for additional waterproofing arrangement for the antenna system 100, and reducing the manufacturing cost of the antenna system 100, and on the other hand, reducing the air resistance of the vehicle 1000 during operation, and improving the operating performance of the vehicle 1000.

The first cross beam 231 and the second cross beam 232 are both disposed above the passenger compartment. The antenna system 100 may also be disposed above the passenger compartment, such that the antenna system 100 is positioned relatively high with fewer surrounding obstructions, thereby enabling the antenna system 100 to better receive and transmit signals, and improving communication quality and stability.

In some embodiments, the first PCB 120 can be disposed as a rectangle. The length of the first PCB 120 in the first direction X is greater than the length of the first PCB 120 in the second direction Y. The global navigation satellite system unit 150 is disposed on the second PCB 130, which is connected to the second end 122 of the first PCB 120. The first direction X is parallel to the left-right direction of the vehicle 1000. In this way, the obstacles in the left-right direction of the vehicle 1000 are reduced for the global navigation satellite system unit 150, and the first cross beam 231 and the second cross beam 232 will not affect the reception of signals by the global navigation satellite system unit 150, improving the operating stability and reliability of the antenna system 100.

By way of example, the first cross beam 231 or the second cross beam 232 may further include a first groove 250 penetrating through upper and lower end surfaces. In the front-rear direction of the vehicle 1000, an opening of the first groove 250 faces the third end 123 of the antenna system 100. In the front-rear direction of the vehicle 1000, the third end 123 of the antenna system 100 is closer to the first groove 250 than the fourth end 124 of the antenna system 100. In this way, the influence of the first cross beam 231 or the second cross beam 232 on the signal transmission and reception of the cellular communication unit 160 and the Bluetooth unit 190 can be reduced.

It should also be noted that the terms "include", "contain" or any other variant thereof, are intended to encompass a non-exclusive inclusion, such that a process, method, article or apparatus comprising a series of elements includes not only those elements, but also other elements not expressly listed, or also include elements inherent to such process, method, article or equipment. Without further limitations, an element defined by the phrase "including a..." does not exclude the presence of additional identical elements in the process, method, article, or equipment including the element.

Each embodiment described in this specification is presented progressively. Similar or identical portions among the embodiments can be mutually cross-referenced, and each embodiment mainly emphasizes the differences from the other embodiments. In particular, as the system embodiments are basically similar to the method embodiments, their descriptions are relatively concise, and for relevant details, reference may be made to the corresponding descriptions in the method embodiments.

The foregoing is merely illustrative of the embodiments of the present application and is not intended to limit the present application. For those skilled in the art, various modifications and variations may be made to the present application. Any modification, equivalent replacement, improvement, or the like made within the spirit and principles of the present application shall be included within the scope of the claims of the present application.

Although the embodiments of the present application have been described with reference to the accompanying drawings, those skilled in the art may make various modifications and variations without departing from the spirit and scope of the present application, and such modifications and variations shall all fall within the scope defined by the appended claims.

## Claims

1. A low-profile built-in vehicle-mounted smart antenna system, comprising:
a Printed Circuit Board (PCB) (110) comprising a first PCB (120) and a second PCB (130), wherein in a first direction (X), the first PCB (120) comprises a first end (121) and a second end (122) disposed opposite to each other, the second PCB (130) is connected to the second end (122), and the first direction (X) is perpendicular to a thickness direction of the PCB (110);
a power supply assembly (140) disposed on the first PCB (120), wherein in the first direction (X), the power supply assembly (140) is closer to the first end (121) than to the second end (122); and
a global navigation satellite system unit (150) disposed on the second PCB (130), wherein the global navigation satellite system unit (150) is adapted to receive satellite signals.

2. The antenna system according to claim 1, wherein in a second direction (Y), the first PCB (120) comprises a third end (123) and a fourth end (124) disposed opposite to each other; a length of the first PCB (120) in the first direction (X) is greater than a length of the first PCB (120) in the second direction (Y); and the first direction (X), the second direction (Y) and the thickness direction of the PCB (110) are mutually perpendicular in pairs.

3. The antenna system according to claim 2, wherein the antenna system comprises a cellular communication unit (160), the cellular communication unit (160) is disposed on the first PCB (120), and in the first direction (X), the cellular communication unit (160) is disposed between the power supply assembly (140) and the second PCB (130).

4. The antenna system according to claim 3, wherein the cellular communication unit (160) comprises a cellular communication primary unit (161) and a cellular communication diversity unit (162), the cellular communication primary unit (161) is disposed at the third end (123), the cellular communication diversity unit (162) is disposed at the second end (122), and in the first direction (X), the cellular communication primary unit (161) is disposed between the power supply assembly (140) and the cellular communication diversity unit (162).

5. The antenna system according to claim 4, comprising a first clearance area (170) and a second clearance area (171), wherein the first clearance area (170) is disposed at the third end (123), the second clearance area (171) is disposed at the second end (122), the cellular communication primary unit (161) is disposed in the first clearance area (170), and the cellular communication diversity unit (162) is disposed in the second clearance area (171); and
in the first direction (X), a length of the first clearance area (170) is 50-70 mm, and a length of the second clearance area (171) is 8-16 mm; and in the second direction (Y), a length of the first clearance area (170) is 8-16 mm, and a length of the second clearance area (171) is 50-70 mm.

6. The antenna system according to claim 4, wherein the PCB (110) comprises a first transition portion (180); in the first direction (X), an end of the first transition portion (180) is connected to the first PCB (120), and an other end of the first transition portion (180) is connected to the second PCB (130); the first transition portion (180) comprises a third clearance area (181) and a first connection area (182); and in the first direction (X), at least a portion of the cellular communication diversity unit (162) is disposed opposite to the third clearance area (181), and a copper-clad portion of the second PCB (130) is electrically connected to a copper-clad portion of the first PCB (120) via the first connection area (182).

7. The antenna system according to claim 1, wherein the copper-clad portion of the second PCB (130) is disposed as a centrosymmetric structure, and the global navigation satellite system unit (150) is disposed as a centrosymmetric structure.

8. The antenna system according to claim 7, wherein the global navigation satellite system unit (150) comprises a first ceramic patch and two first pins disposed on the first ceramic patch, and the two first pins are soldered to the second PCB (130).

9. The antenna system according to claim 8, wherein the global navigation satellite system unit (150) further comprises a second ceramic patch and two second pins disposed on the second ceramic patch; in the thickness direction of the PCB (110), the first ceramic patch and the second ceramic patch are stacked, the second ceramic patch is closer to the second PCB (130) than the first ceramic patch, the two second pins are soldered to the second PCB (130), and the two first pins pass through the second ceramic patch and are soldered to the second PCB (130).

10. The antenna system according to claim 9, wherein in the thickness direction of the PCB (110), a first bonding layer is disposed between the second ceramic patch and the second PCB (130), a first foam layer is disposed between the first ceramic patch and an upper cover of the antenna system, and the first foam layer abuts against the first ceramic patch and the upper cover of the antenna system, respectively.

11. The antenna system according to claim 4, comprising a Bluetooth unit (190), wherein the Bluetooth unit (190) is disposed at the third end (123), and in the first direction (X), the Bluetooth unit (190) is disposed between the cellular communication primary unit (161) and the first end (121).

12. The antenna system according to claim 11, wherein the Bluetooth unit (190) is etched on the third end (123) of the first PCB (120);
or, a shortest distance between the Bluetooth unit (190) and the cellular communication primary unit (161) is half a dielectric wavelength;
or, the antenna system further comprises a Bluetooth chip (200) and a communication chip (210), wherein a Bluetooth signal excitation radio frequency link is disposed between the Bluetooth chip (200) and the Bluetooth unit (190), the Bluetooth signal excitation radio frequency link comprises a set of pi-type topology matching positions, a cellular signal excitation primary radio frequency link is disposed between the communication chip (210) and the cellular communication primary unit (161), a cellular signal excitation diversity radio frequency link is disposed between the communication chip (210) and the cellular communication diversity unit (162), and both the cellular signal excitation primary radio frequency link and the cellular signal excitation diversity radio frequency link comprise two sets of pi-type topology matching positions.

13. The antenna system according to claim 4, wherein the cellular communication primary unit (161) comprises a plurality of first plug-in pins, the cellular communication diversity unit (162) comprises a plurality of second plug-in pins, and the plurality of first plug-in pins and the plurality of second plug-in pins are all used for signal excitation and grounding as well as structural fixation and support; and in the thickness direction of the PCB (110), a plurality of first holes and a plurality of second holes penetrating through the first PCB (120) are disposed in the first PCB (120), each of the plurality of first plug-in pins is fitted into a corresponding first hole, and each of the plurality of second plug-in pins is fitted into a corresponding second hole.

14. A vehicle, comprising the antenna system according to any one of claims 1 to 13.

15. The vehicle according to claim 14, comprising:
a vehicle frame (230) comprising a first cross beam (231) and a second cross beam (232), wherein the first cross beam (231) and the second cross beam (232) are spaced apart in a front-rear direction of the vehicle, and both the first cross beam (231) and the second cross beam (232) are disposed above a passenger compartment; and
in the front-rear direction of the vehicle, the antenna system is disposed between the first cross beam (231) and the second cross beam (232) and connected to the first cross beam (231) and
the second cross beam (232) via connecting members (240), and the first direction (X) is parallel to at least one of a lengthwise direction of the first cross beam (231) and a lengthwise direction of the second cross beam (232).
